# EUROPEAN PATENT APPLICATION

(11) **EP 1 610 598 A1**
(43) Date of publication of application: **28.12.2005**
(21) Application number: 05253828.7
(22) Date of filing: 21.06.2005
(51) Int. Cl.: H05K 3/28

(54) **Anti-hacking printed circuit board having high-molecular material deposited thereon and deposition method for the same**

(30) Priority: 22.06.2004 KR 2004046614
(71) Applicant: SAMSUNG ELECTRONICS CO., LTD., Suwon-si, Gyeonggi-do (KR)
(72) Inventor: Lee, Eun-Lai, Suwon-si Gyeonggi-do (KR)
(74) Representative: Robinson, Ian Michael

(57) **Abstract**

Disclosed are a set-top box configured for preventing hacking through microelectronic devices (150) or wirings (510) on a printed circuit board therein, and a method of depositing a high-molecular material (520) therefor. The prevention of hacking within a set-top box is obtained by depositing and curing a liquid high-molecular material (520), which includes epoxy and a curing agent, on an area(s) of microelectronic devices (150) or on an area(s) of wirings (510) connecting the microelectronic devices (150) through which the interior of the set-top box may be hacked. In addition, the liquid high-molecular material (520) is deposited in a frame (600) manufactured to a size and shape desired for deposition around the area(s) to deposit the high-molecular material (520) in uniform dimensions and height and thereby reduce manufacturing cost.

## Description

The present invention relates in general to a printed circuit board to prevent or deter backing, and a method of making the same. The present invention also relates to an electronic apparatus having hardware security, such as a set-top box for pay broadcast.

Recently, digitalization of broadcasting media has progressed rapidly in many countries. With the progress of the digitalization of broadcasting media, the digital set-top box market has grown significantly.

The digital set-top box is a receiver capable of receiving digital broadcast signals, such as satellite broadcast signals, cable broadcast signals, ground wave broadcast signals, and so on, and is a kind of digital multimedia apparatus that receives digital broadcast (video/audio) signals in a form compressed by MPEG-2 and transmits the received digital broadcast signals to a display apparatus such as a television (TV) is becoming of greater interest.

Such digital set-top boxes are generally classified into simple digital set-top boxes and pay broadcast digital set-top boxes.

The simple digital set-top box is used for free channels or for satellite broadcast business allowing all subscribers to see and hear the satellite broadcast, and is generally called a free-to-air (FTA) receiver.

In contrast, the pay broadcast digital set-top box is a receiver having a conditional access system (hereinafter, referred to as "CAS"), which enables only viewers paying a predetermined price to see and hear a specific broadcast, such as an adult broadcast, scrambled according to the business strategy of a broadcasting provider.

A hardware device comprising such a CAS to descramble scrambled broadcasting signals is generally called a conditional access module (hereinafter, referred to as "CAM").

The CAM has a CAS function, which enables a user to see and hear a pay broadcast, as a PCMCIA module separated from a digital set-top box. CAMs are classified into various types according to methods of scrambling broadcasting signals.

For example, a different type of CAM is designed according to a Viaccess method, a Nagravision method, a Conax method, an NDS method, and an Irdeto method, among others, which are not compatible with one another.

In order to solve such incompatibility, the CAM is installed on the exterior of a set-top box, and a common interface (CI) is provided between the CAM and the set-top box. Therefore, it is enough for a viewer to connect a smart card provided by a broadcasting-station party to the CAM, and it is unnecessary to take the scrambling method employed in the CAM into account.

As described above, since the conventional pay broadcast set-top box employs a common interface method, it is possible to use a pay-per-view method, which enables a customer to pay a fee according to the amount of seeing/hearing time after a viewer sees/hears a pay broadcast provided by a broadcasting provider.

However, although such a common interface method is employed, a customer may avoid fee payment by hacking through contacting microelectronic devices mounted on a printed circuit board and/or wirings connected between them. Therefore, it is desired to fabricate a digital set-top box having a security device to protect the hardware, as well as a security function to protect the software.

The present invention addresses the above-mentioned problems occurring in the prior art. A preferred aim of the present invention is to provide a printed circuit board that can prevent hardware hacking of the printed circuit board.

The present invention provides a printed circuit board on which high-molecular material is deposited to prevent hacking and a method of depositing the high-molecular material. More particularly, the present invention provides a printed circuit board on which a high-molecular material for curing, which has an adhesive property, is deposited to prevent hacking of at least one of corresponding areas for microelectronic devices and wirings in an electronic apparatus requiring hardware security such as a set-top box for pay broadcast.

In one aspect of the present invention there is provided a printed circuit board for preventing hacking, comprising: microelectronic devices mounted on the printed circuit board; wirings for electrically connecting the microelectronic devices to each other; and an adhesive high-molecular material which is cured on at least one area from among the areas corresponding to respective ones of the microelectronic devices and of the wirings.

In accordance with another aspect of the present invention, there is provided a method of depositing a high-molecular material on a printed circuit board, the method comprising the steps of: disposing a frame to surround a microelectronic device in the printed circuit board; and depositing the high-molecular material in the frame.

The above and other objects, features and advantages of the present invention will be more apparent from the following detailed description taken in conjunction with the accompanying drawings, in which:
Figure 1 is a block diagram showing a conventional set-top box and a CAM connected with the set-top box;
Figure 2 is a perspective view showing a conventional central processing unit, which is a semiconductor, mounted on a printed circuit board of a set-top box;
Figure 3 is a front view of the central processing unit in Figure 2 mounted on a printed circuit board;
Figures 4A and 4B are views illustrating a method for preventing hacking of the central processing unit in Figure 2 according to an embodiment of the present invention; and
Figures 5A to 5D are views for views for illustrating a method for depositing a high-molecular material on a printed circuit board according to an embodiment of the present invention.

Hereinafter, embodiments of the present invention will be described in detail with reference to the accompanying drawings. Advantages and features of the present invention, and methods for achieving them, will be apparent to those skilled in the art from the detailed description of the embodiments together with the accompanying drawings. However, the scope of the present invention is not limited to embodiments disclosed in the specification. Additionally, the same reference numerals are used to designate the same elements throughout the specification and drawings.

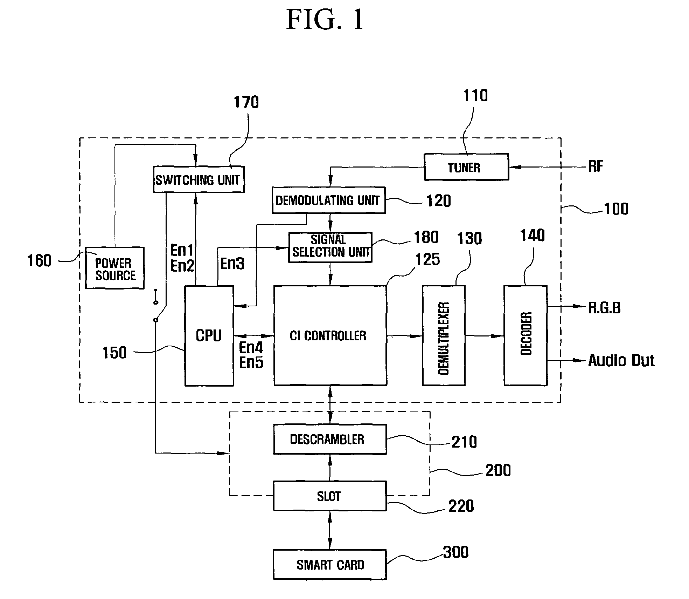

Figure 1 is a block diagram showing a conventional set-top box and a CAM connected with the set-top box employed in the present invention.

Referring to Figure 1, a set-top box 100 includes a tuner 110, a demodulating unit 120, a demultiplexer 130, a decoder 140, a central processing unit (CPU) 150, a common interface controller (CI controller) 125, a power source 160, a switching unit 170, and a signal selection unit 180.

In addition, a conditional access module (hereinafter referred to as 'CAM') 200 shown in Figure 1 includes a descrambler 210 and a slot 220. The slot 220 is formed so that a smart card 300 can be inserted into and removed from the slot 220.

The tuner 110 receives ground waves and digital satellite broadcast radio waves from broadcasting stations, and selects one channel according to adjustment of a remote controller from the exterior or setting keys installed on a video display device, such as a television.

The demodulating unit 120 demodulates a broadcast signal of a channel received through the tuner 110 and converts the received broadcast signal into a data stream. The demodulated data stream is transferred to the CAM 200 through the signal selection unit 180 and the common interface controller 125.

The demultiplexer 130 receives a descrambled data signal from the CAM 200 through the common interface controller 125, and divides the descrambled data signal into a video signal and an audio signal.

The decoder 140 decodes the video signal and the audio signal, which are generated by a dividing process of the demultiplexer 130, respectively, and outputs the respective decoded signals.

In general, a decoder outputs a video signal after the decoder converts the video signal into an RGB format, and applies the outputted video signal to a video display device, such as a television, connected to the set-top box 100.

Herein, the decoder 140 may employ a composite method or a component format, as well as an RGB format, as an output format for a video signal.

The common interface controller 125 is a device for monitoring the attribute of a digital satellite broadcast signal provided from the signal selection unit 180.

As a result of the monitoring in the common interface controller 125, when it is determined that the digital satellite broadcast signal is a free broadcast signal, the common interface controller 125 bypasses the digital satellite broadcast signal directly to the demultiplexer 130. In contrast, when it is determined that the digital satellite broadcast signal is a pay broadcast signal, the common interface controller 125 outputs the digital satellite broadcast signal to the descrambler 210.

After this, the common interface controller 125 receives a descrambled digital satellite broadcast signal from the descrambler 210, and outputs the descrambled digital satellite broadcast signal to the demultiplexer 130.

The central processing unit 150 preferably controls the entire operation of the set-top box 100.

That is, the central processing unit 150 controls the operations of the tuner 110, the demodulating unit 120, the common interface controller 125, the demultiplexer 130, the decoder 140, and the switching unit 170, in response to the operation of a remote controller or the operation of setting keys installed on a video display device, such as a television.

For example, when a viewer presses a channel change key, the central processing unit 150 controls the tuner 110 to achieve the pressed function in response to the operation of the pressed channel change key. When a viewer presses a setting key to change the tone of color displayed on a video display device, the central processing unit 150 controls the decoder 140 to change the tone of color according to the pressed setting key.

In addition, when it is determined with reference to a data stream outputted from the demodulating unit 120 that an input signal is a free broadcast signal, the central processing unit 150 outputs control signals En1 and En2 to the switching unit 170 to be turned on/off, outputs a control signal En3 to the signal selection unit 180, and outputs control signals En4 and En5 to the common interface controller 125, so that the data stream is applied from the signal selection unit 180 to the demultiplexer 130 through the common interface controller 125.

Also, in the central processing unit 150, a memory (for example, an EPROM, an EEPROM, or a flash memory) stores a program for determining whether an applied signal is a pay broadcast signal or a free broadcast signal.

The power source 160 may be obtained by rectifying an alternating current voltage supplied from the exterior or may be an accommodated battery. The power source 160 supplies power to drive the set-top box 100 and the CAM 200 connected with the set-top box 100.

The switching unit 170 cuts off the power supplied from the power source 160 to the CAM 200 when it is unnecessary to perform a descrambling process for data corresponding to a control signal which is applied to the central processing unit 150 by an operation of a remote controller or a setting key.

In general, one part of broadcast signals transmitted via a satellite are scrambled signals and the other part are descrambled signals. Scrambled broadcast signals are pay broadcast signals, and descrambled broadcast signals are free broadcast signals. Also, a program, such as urgent news, may be descrambled.

Herein, it is unnecessary that the CAM 200 operates to perform a descrambling operation whenever the set-top box 100 is turned on, that is, it is reasonable to turn off the power applied to CAM 200 when there is no pay broadcast signal to be applied into the CAM 200.

Therefore, the central processing unit 150 determines whether an inputted signal is a pay broadcast signal or a free broadcast signal with reference to a data stream demodulated in the demodulating unit 120 and controls the switching unit 170 according to results of the judgment.

The signal selection unit 180 applies a data stream, which is outputted from the demodulating unit 120, into the descrambler 210 of the CAM 200 or into the demultiplexer 130 through the common interface controller 125 in response to the control signal En3.

The CAM 200 includes the descrambler 210 and the slot 220.

The descrambler 210 receives a data stream, which is outputted from the demodulating unit 120, through the common interface controller 125, descrambles the received data stream, and provides the descrambled signal to the common interface controller 125. The common interface controller 125 receives the descrambled signal and outputs the received signal to the demultiplexer 130.

The slot 220 is preferably an interface of a PCMCIA-type to be connected with the smart card 300 which can be assembled/disassembled from/to the exterior. The slot 220 is connected with the smart card 300, which provides a part of an algorithm for a predetermined descrambling operation to the slot 220.

The smart card 300 stores a part of a descrambling algorithm to be performed by the descrambler 210, so that the descrambler 210 can form a complete algorithm when the smart card 300 is connected to the slot 220. Such a smart card 300 is provided from a broadcasting party to viewers who are under a contract with the broadcasting party.

Hereinafter, a signal flow in the digital set-top box will be described in detail with reference to Figure 1.

When the set-top box 100 is powered on, digital satellite broadcast signals (RF) are inputted to the tuner 110. The tuner 110, having received the digital broadcast signals, selects one channel in response to a selection via a setting key, such as a setting key in a remote controller.

A digital video signal corresponding to the selected channel is transferred to the demodulating unit 120. The demodulating unit 120 demodulates the broadcast signal of the selected channel to convert the broadcast signal into a data stream.

Then, the demodulated data stream is applied to the central processing unit 150. The central processing unit 150 determines whether the received data stream corresponds to "1" or "0" according the program stored in a memory associated therewith, and thereby determines whether the received data stream corresponds to a scrambled pay broadcast "1" or a descrambled free broadcast "0". It is to be understood that the data stream can comprise other markers or ancillary data to designate the data stream as comprising a scrambled pay broadcast or a descrambled free broadcast.

As a result of the determination in the central processing unit 150, when a broadcast signal selected by the tuner 110 corresponds to a descrambled free broadcast "0", the central processing unit 150 outputs the control signal En1 to the switching unit 170 to cut off power supplied to the CAM 200, thereby inactivating the CAM 200.

In addition, the central processing unit 150 outputs the control signal En3 to the signal selection unit 180, thereby ordering the signal selection unit 180 to transmit a broadcast signal being in a data stream format to the common interface controller 125. Simultaneously, the central processing unit 150 outputs the control signal En5 to the common interface controller 125, thereby ordering the common interface controller 125 to output the data stream, which is received from the signal selection unit 180, directly to the demultiplexer 130.

The demultiplexer 130, which has received the data stream, divides the received data stream into video signals and audio signals and transfers the divided signals to the decoder 140. The decoder 140 converts the video signals into an RGB format and outputs the converted video signals to an exterior video display device, such as a television.

In contrast, as a result of the determination in the central processing unit 150, when the broadcast signal selected by the tuner 110 corresponds to a scrambled pay broadcast, the central processing unit 150 outputs the control signal En2 to the switching unit 170 to supply power to the CAM 200, thereby activating the CAM 200.

In addition, the central processing unit 150 outputs the control signal En3 to the signal selection unit 180, thereby ordering the signal selection unit 180 to transmit a broadcast signal being in a form of a data stream to the common interface controller 125.

Simultaneously, the central processing unit 150 outputs the control signal En4 to the common interface controller 125, thereby ordering the common interface controller 125 to output the data stream, which is received from the signal selection unit 180, to the CAM 200.

Then, the CAM 200 determines whether or not the smart card 300 is inserted into the PCMCIA slot 220. As a result of this determination, when the smart card 300 is inserted into the slot 220, the CAM 200 reads a partial descrambling algorithm stored in the smart card 300 through the slot 220 and provides the read algorithm to the descrambler 210.

After this, the descrambler 210 completely descrambles an applied data stream signal using the algorithm provided from the smart card 300, and provides the descrambled signal to the common interface controller 125.

Since the signal provided to the common interface controller 125 is a descrambled signal, the central processing unit 150 outputs the control signal En5 to the common interface controller 125, thereby ordering the common interface controller 125 to transfer the descrambled signal to the demultiplexer 130.

The descrambled signal passes through the demultiplexer 130 and the decoder 140, and finally is applied to a video display device, such as a television.

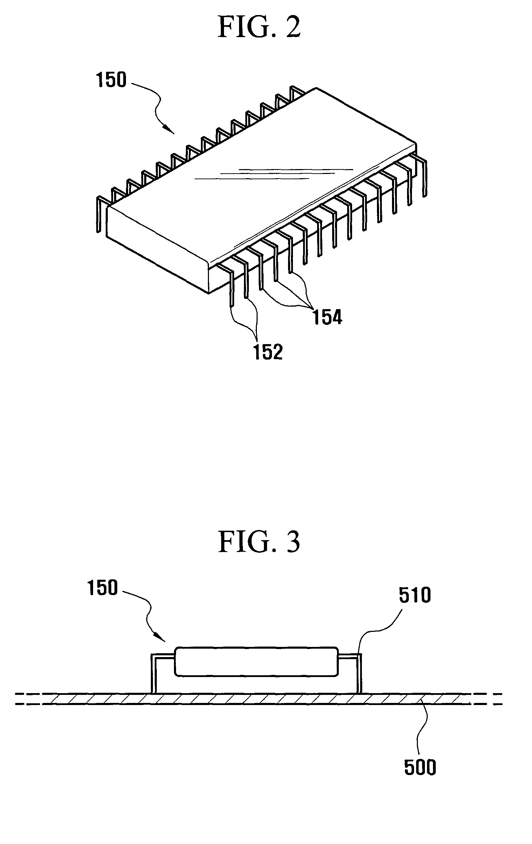

Figure 2 is a perspective view showing a central processing unit 150, which is a semiconductor, mounted on a printed circuit board of a set-top box.

Referring to Figure 2, the central processing unit 150 includes a memory (not shown) in which an algorithm for determining whether a signal is a pay broadcast signal or a free broadcast signal is programmed.

Reading and writing data from/into this memory can be performed through two pins of a serial port method, which are called U-Ports 152, of the central processing unit 150.

Also, the central processing unit 150 is controlled through three pins, which are called JTAG (Joint Test Action Group) 154, by a manufacturer of the central processing unit 150.

The other pins mounted on the semiconductor package of the central processing unit 150, except for the above-mentioned pins 152 and 154, are used to apply control signals to the switching unit 170, the signal selection unit 180, and the common interface controller 125, or to exchange a signal with another microelectronic device.

Figure 3 is a front view of the central processing unit 150 mounted on a printed circuit board 500.

As shown in Figure 3, pins 510, which extend from the central processing unit 150, are soldered on a printed circuit board 500.

A portion of the pins 510 are still exposed to the exterior even after the pins 510 are soldered on the printed circuit board 500.

Since these pins 510 include U-Port and JTAG pins as described above, the central processing unit 150 can be hacked through the U-Port or JTAG pins physically from the exterior.

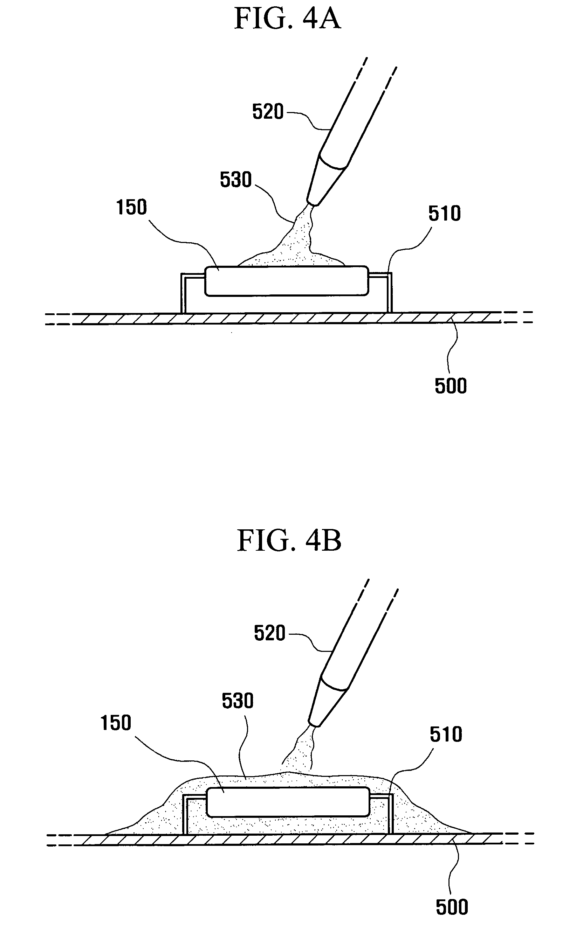

Figures 4A and 4B are views for explaining a method for preventing hacking of the central processing unit 150 according to one embodiment of the present invention.

As shown in Figure 4A, a liquid high-molecular material 530 for curing is deposited on the central processing unit 150, which is mounted on the printed circuit board 500, using a means 520, such as a tube or a nozzle, which enables a predetermined amount of high-molecular material to be deposited.

It is preferred that the liquid high-molecular material 530 is deposited to cover the entire area of the central processing unit 150, as shown in Figure 4B.

When a predetermined period of time elapses, the liquid high-molecular material 530 cures to a solid state and strongly adheres to the central processing unit 150. Therefore, if a user attempts to separate the cured high-molecular material 530 from the central processing unit 150, the central processing unit 150 is detached from the printed circuit board 500 due to a high adhesive strength and prevents operation thereof and therefore also the playback of a broadcast signal by the set-top box.

In consideration of easy deposition, the high-molecular material 530 is preferably a liquid having viscosity. Also, the substance used as the high-molecular material 530 preferably cures when a predetermined period of time has elapsed, (e.g., preferably when one hour elapses after the substance is deposited), and has a high adhesive strength to a semiconductor device.

As a preferred material capable of satisfying such characteristics, a substance comprising liquid epoxy and a curing agent is used. In accordance with one embodiment of the present invention, a 2214 regular product manufactured by the 3M Company is employed as liquid epoxy, and a curing product for epoxy manufactured by the 3M Company is employed as a curing agent.

In the above description, the method for preventing hacking by using a high-molecular material for curing has been implemented, for illustrative purposes, with the central processing unit 150 from among microelectronic devices mounted on the printed circuit board which is accommodated in the set-top box.

Alternatively, in accordance with another embodiment of the present invention, the high-molecular material can be applied to other semiconductor devices in the set-top box besides the central processing unit 150 such as, but not limited to, the descrambler 210, the common interface controller 125, and the signal selection unit 180, and wiring areas connected among them that are exposed to the exterior. This is because, when a hacker hacks semiconductor devices besides the central processing unit, the hacker can obtain an effect identical to that obtained when the hacker hacks the central processing unit 150, even without directly hacking the central processing unit, because the devices are interconnected with the central processing unit.

Also, a memory device of the set-top box is generally accommodated in the central processing unit 150, but the memory device may be separated from the central processing unit and installed externally thereto. In this case, it is preferred that the high-molecular material is deposited on the memory device so as to prevent hacking of the memory device.

As described above, the above-mentioned high-molecular material for curing is deposited not only on the central processing unit 150 but also on the other semiconductor devices and the wiring areas connected among them, through which a viewer having no smart card may physically perform hacking from the exterior so as to see and hear a pay broadcast, so that hacking of hardware from the exterior can be completely prevented.

Meanwhile, when the liquid high-molecular material is deposited on the semiconductor device or the wiring area directly by a tube or a different means as described above, the liquid high-molecular material may spread to other areas outside of a desired deposition area due to the fluidity of the liquid high-molecular material.

It can be difficult to consistently set a thickness of the deposited high-molecular material, causing the amount of deposited high-molecular material to increase and therefore the manufacturing cost to increase.

Figures 5A to 5D are views for views for explaining a method for depositing a high-molecular material on a printed circuit board according to another embodiment of the present invention.

First, as shown in Figure 5A, a frame 600, which has a desired shape and a desired size, is disposed at a position desired for deposition of a liquid high-molecular material.

In this case, the desired deposition position may include microelectronic device areas and/or wiring areas. Also, the shape of the frame may be changed according to a position, dimensions, and a shape of an area, to which the liquid high-molecular material is to be deposited. For example, the frame is disposed to surround a microelectronic device selected for deposition, wherein the adhesive high-molecular material is deposited within the frame. In addition, it is preferred that the frame is at least higher than the height of a microelectronic device on which the high-molecular material is to be deposited. The frame may have various shapes, and preferably, the frame has a hexahedron shape.

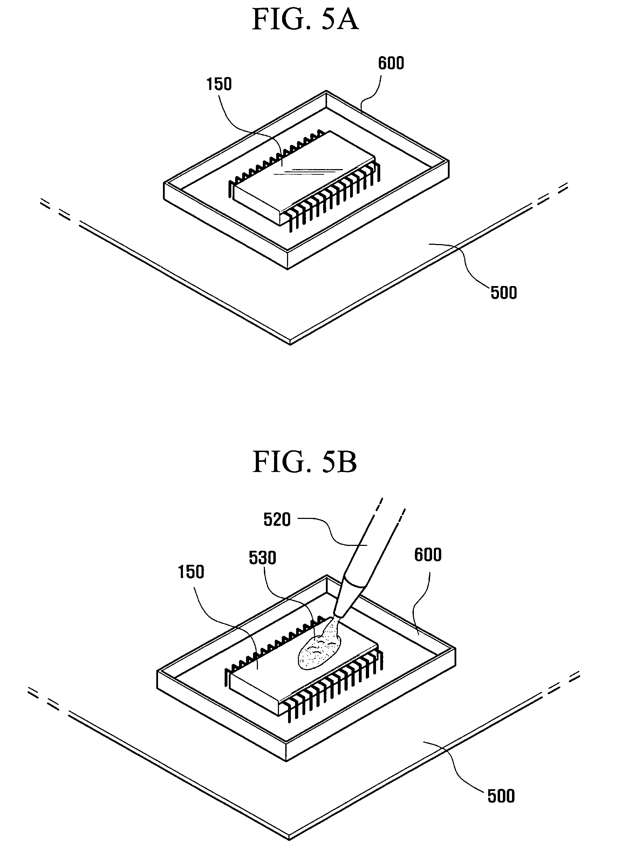

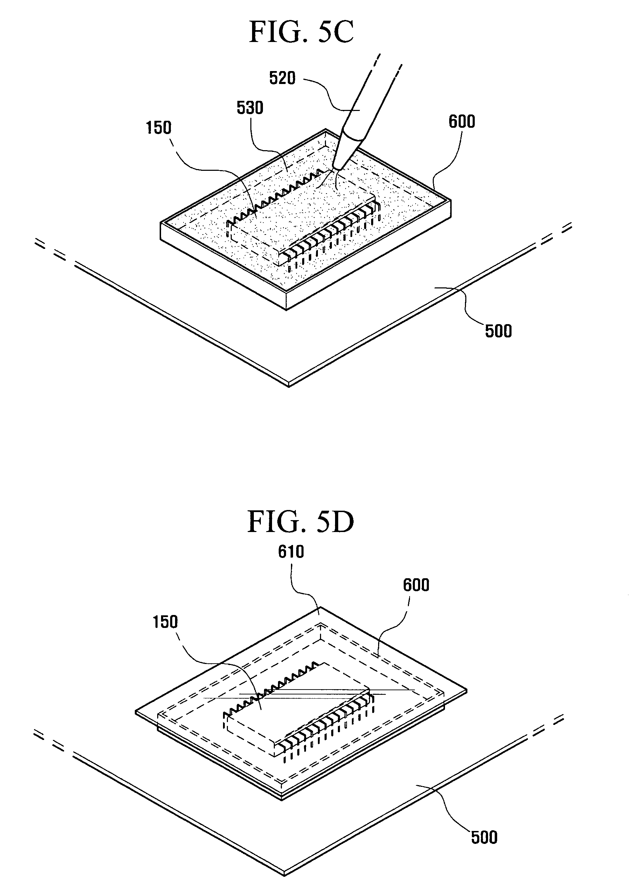

Next, a tube 520 as shown in Figure 5B begins to inject the liquid high-molecular material into the frame 600, and then the injection continues until the inside of the frame 600 is filled with the liquid high-molecular material as shown in Figure 5C.

In this case, it is preferred that an epoxy mixed with a curing agent is used as the high-molecular material. Also, although the tube is used as an injecting means, it is to be understood that other means capable of providing the same effect as that of the tube can be used as an injecting means.

Finally, as shown in Figure 5D, the injected liquid high-molecular material is covered with a cap 610 which has dimensions at least to cover the entire frame 600. The cap prevents high-molecular material from contacting any device external to the frame before the high-molecular material is cured.

The reason why the frame 600, into which the liquid high-molecular material is injected, is covered with the cap 610 is related to a process of fabricating the set-top box.

That is, a process of depositing a liquid high-molecular material for security, as described above, is performed a step just before an assembling step for a finished product in a set-top box manufacturing process, and a predetermined period of time is required until the liquid high-molecular material is cured into a solid state after the liquid high-molecular material is deposited.

Therefore, if an upper case of the set-top box is assembled before the liquid high-molecular material is cured, electric wirings and/or some devices accommodated in the set-top box may be marred with the liquid high-molecular material.

In contrast, if the assembling step for a finished product is delayed until the liquid high-molecular material is completely cured, productivity is lowered.

Therefore, after the liquid high-molecular material is injected into the frame 600, the cap 610 is provided over the frame 600 as a protective film, so that such a problem can be solved.

As described above, a printed circuit board having a high-molecular material deposited thereon and a method of depositing the high-molecular material according to the present invention provides effects as follows.

First, since a high-molecular material for curing having a high adhesive strength is deposited on an area of microelectronic devices mounted on a printed circuit board or on an area of wirings electrically connecting the microelectronic devices, which are accommodated in an electronic apparatus such as a set-top box that may be hacked, it is possible to prevent hacking via external physical force.

Secondly, the deposition of the high-molecular material for curing is performed not directly on a target, but by a method of injecting the high-molecular material for curing into a frame, which has been manufactured to be suitable to a size and a shape of a desired deposition area, after the frame is disposed at the desired deposition area, so that the amount of the high-molecular material to be required for the above-mentioned deposition decreases, thereby reducing a manufacturing cost. In addition, spreading of the deposited high-molecular material out of the desired deposition area is prevented, thereby preventing a undesired area from being marred.

Although a few preferred embodiments have been shown and described, it will be appreciated by those skilled in the art that various changes and modifications might be made without departing from the scope of the invention, as defined in the appended claims.

Attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings) may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. A printed circuit board for preventing hacking, comprising:
microelectronic devices (150) mounted on the printed circuit board;
wirings (510) for electrically connecting the microelectronic devices (150) to each other; and
an adhesive high-molecular (520) material which is cured on at least one area selected from among respective areas corresponding to the microelectronic devices (150) and respective areas corresponding to the wirings (510).

2. The printed circuit board of claim 1, further comprising a frame (600) which is disposed to surround a microelectronic device selected for deposition, wherein the adhesive high-molecular material (520) is deposited within the frame (600).

3. The printed circuit board of claim 2, wherein the frame (600) comprises a cap (610) for preventing the high-molecular material (520) from contacting any device external to the frame (600) before the high-molecular material (520) is cured.

4. The printed circuit board of claim 1, 2 or 3, wherein the high-molecular material (520) comprises liquid epoxy and a curing agent.

5. A method of depositing a high-molecular material (520) on a printed circuit board, the method comprising the steps of:
disposing a frame (600) to surround a microelectronic device (150) on the printed circuit board; and
depositing the high-molecular material (520) in the frame (600) to prevent the high-molecular material (520) from spreading to a undesired area and reduce the deposition amount of the high-molecular material (520).

6. The method of claim 5, further comprising a step of covering the frame (600) with a cap (610) that covers the entire dimensions of the frame (600) and prevents the high-molecular material (520) from contacting any device external to the frame (600).

7. The method of claim 5, wherein the high-molecular material (520) comprises liquid epoxy and a curing agent.

8. A set-top box for preventing hacking, comprising:
microelectronic devices (150) which are mounted on the printed circuit board;
wirings (510) for electrically connecting the microelectronic devices (150) to each other; and
an adhesive high-molecular material (520) which is cured on at least one area selected from among respective areas corresponding to the microelectronic devices (150) and respective areas corresponding to the wirings (510).

9. The set-top box of claim 8, further comprising a frame (600) which is disposed to surround a microelectronic device (150) selected for deposition, wherein the adhesive high-molecular material (520) is deposited within the frame (600).

10. The set-top box of claim 9, wherein the frame (600) comprises a cap (610) for preventing the high-molecular material (520) from contacting any device external to the frame (600) before the high-molecular material (520) is cured.

11. The set-top box of claim 8, 9 or 10, wherein the microelectronic device is selected from a group comprising a signal selection unit (180) , a descrambling unit (210), a common interface controller (125), a central processing unit (150), a signal outputting unit, and a memory unit.

12. The set-top box of any of claims 8 to 11, wherein the high-molecular material (520) comprises a liquid epoxy and a curing agent.

13. The set-top box of any of claims 8 to 12, wherein the high-molecular material (520) cures when approximately one hour has elapsed after it is deposited.

14. The set-top box of any of claims 8 to 13, wherein the high-molecular material (520) has a high adhesive strength to a semiconductor device.
